# EUROPEAN PATENT APPLICATION

(11) **EP 4 549 974 A1**
(43) Date of publication of application: **07.05.2025**
(21) Application number: 24747468.7
(22) Date of filing: 25.01.2024
(51) Int. Cl.: G01R 31/392, G01R 31/396, G01R 31/385, G01R 31/3842, G01R 19/30, G01R 19/165, H01M 10/0525, G01R 31/382

(54) **BATTERY DIAGNOSIS DEVICE AND METHOD**

(30) Priority: 25.01.2023 KR 20230009769; 25.01.2023 KR 20230009770
(71) Applicant: LG Energy Solution, Ltd., Seoul 07335 (KR)
(72) Inventor: KIM, Yong-Jun, Daejeon 34122 (KR); BAE, Yoon-Jung, Daejeon 34122 (KR)
(74) Representative: Plasseraud IP
(86) International application number: PCT/KR2024/001227
(87) International publication number: WO 2024/158235

(57) **Abstract**

An apparatus for diagnosing a battery according to an embodiment of the present disclosure includes a storage unit configured to store bank information about voltage and capacity of each of a plurality of battery banks included in a battery module; and a control unit configured to generate a differential profile for each of the plurality of battery banks based on the bank information, determine a target peak in each of the generated plurality of differential profiles, and diagnose the state of the corresponding battery bank based on the determined target peak.

## Description

### TECHNICAL FIELD

The present application claims priority to Korean Patent Application No. 10-2023-0009769 filed on January 25, 2023 in the Republic of Korea and Korean Patent Application No. 10-2023-0009770 filed on January 25, 2023 in the Republic of Korea, the disclosures of which are incorporated herein by reference.

The present disclosure relates to an apparatus and method for diagnosing a battery, and more particularly, to an apparatus and method for diagnosing a battery, which is capable of diagnosing a state of a battery bank and/or a battery module.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being done on these batteries in terms of increasing capacity and density, improvements in lifespan and safety are also important. **In** order to improve battery safety, technology to accurately diagnose the current state of the battery is required.

**In** particular, it is necessary to prevent lithium precipitation on the surface of the negative electrode (lithium plating, Li-plating). When lithium is precipitated on the surface of the negative electrode, it causes side reactions with the electrolyte and changes in the kinetic balance or the like of the battery, causing battery deterioration. **In** addition, as lithium metal is precipitated on the surface of the negative electrode, an internal short circuit of the battery may occur, and thus there is a risk of ignition or explosion due to an internal short circuit. Therefore, there is a need to develop technology that can prevent lithium metal from precipitation by diagnosing the state of the battery.

### DISCLOSURE

### Technical Problem

The present disclosure is designed to solve the problems of the related art, and therefore the present disclosure is directed to providing an apparatus and method for diagnosing a battery, which diagnoses the state of a battery bank and/or a battery module.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a storage unit configured to store bank information about voltage and capacity of each of a plurality of battery banks included in a battery module; and a control unit configured to generate a differential profile for each of the plurality of battery banks based on the bank information, determine a target peak in each of the generated plurality of differential profiles, and diagnose the state of the corresponding battery bank based on the determined target peak.

The control unit may be configured to generate a differential profile representing the corresponding relationship between the voltage and a differential capacity of each of the plurality of battery banks, and determine the target peak included in a preset criterion voltage section in each of the generated plurality of differential profiles.

The control unit may be configured to diagnose the state of a battery bank, where the number of the determined target peaks is less than or equal to the number of criterion peaks included in the criterion voltage section of a preset criterion differential profile, as a normal state.

The control unit may be configured to diagnose the state of a battery bank, where the number of the determined target peaks exceeds the number of the criterion peaks, as an abnormal state.

The criterion differential profile may be preset to show the corresponding relationship between the voltage and the differential capacity of a criterion battery bank.

The control unit may be configured to diagnose the state of the corresponding battery bank as an abnormal state, when the number of the determined target peaks exceeds the number of the criterion peaks and a voltage difference between the target peaks is greater than or equal to a preset threshold voltage.

The control unit may be configured to generate a differential profile representing the corresponding relationship between the capacity and a differential voltage of each of the plurality of battery banks based on the bank information, and determine a target peak included in a preset criterion capacity section in each of the generated plurality of differential profiles.

The control unit may be configured to diagnose the state of a battery bank, where the number of the determined target peaks is less than or equal to the number of criterion peaks included in the criterion capacity section of a preset criterion differential profile, as a normal state.

The control unit may be configured to diagnose the state of a battery bank, where the number of the determined target peaks exceeds the number of the criterion peaks, as an abnormal state.

The criterion differential profile may be preset to show the corresponding relationship between the capacity and the differential voltage of a criterion battery bank.

The control unit may be configured to diagnose the state of the corresponding battery bank as an abnormal state, when the number of the determined target peaks exceeds the number of the criterion peaks and a capacity difference between the target peaks is greater than or equal to a preset threshold value.

The control unit may be configured to calculate an abnormal ratio representing a ratio of an abnormal state among the plurality of battery banks, and diagnose the state of the battery module as a normal state or an abnormal state based on the abnormal ratio.

When the abnormal ratio is less than a preset threshold ratio, the control unit may be configured to diagnose the state of the battery module as the normal state.

When the abnormal ratio is greater than or equal to the threshold ratio, the control unit may be configured to diagnose the state of the battery module as the abnormal state.

The control unit may be configured to change a charging condition preset for the battery module, when the state of the battery module is diagnosed as an abnormal state.

The control unit may be configured to alleviate a rapid charging condition of the battery module by reducing a maximum charging C-rate preset for the battery module, when the state of the battery module is diagnosed as an abnormal state.

The control unit may be configured to select a criterion capacity in which the differential voltage corresponding to a reference differential profile preset for a criterion battery bank is minimum, select a criterion voltage corresponding to the criterion capacity in a criterion bank profile preset for the criterion battery bank, and set a voltage section less than or equal to the criterion voltage as the criterion voltage section.

The reference differential profile may be preset to represent the corresponding relationship between the capacity and the differential voltage of the criterion battery bank.

The criterion bank profile may be preset to represent the corresponding relationship between the voltage and the capacity of the criterion battery bank.

The control unit may be configured to select a criterion capacity in which the corresponding differential voltage in a preset criterion differential profile is minimum, and set a capacity section less than or equal to the criterion capacity as the criterion capacity section.

A battery pack according to another aspect of the present disclosure may comprise the apparatus for diagnosing a battery according to one aspect of the present disclosure.

A method for diagnosing a battery according to still another aspect of the present disclosure may comprise a storing step of storing bank information about voltage and capacity of each of a plurality of battery banks included in a battery module; a differential profile generating step of generating a differential profile for each of the plurality of battery banks based on the bank information; a target peak determining step of determining a target peak in each of the generated plurality of differential profiles; and a diagnosing step of diagnosing the state of the corresponding battery bank based on the determined target peak.

### Advantageous Effects

According to one aspect of the present disclosure, the apparatus for diagnosing a battery has the advantage of accurately diagnosing the state of a battery bank and/or a battery module by considering the imbalanced degeneration of the plurality of battery cells.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing an exemplary configuration of a battery bank and a battery module according to an embodiment of the present disclosure.
FIG. 3 is a diagram schematically showing a differential profile according to an embodiment of the present disclosure.
FIG. 4 is a diagram schematically showing a criterion differential profile according to an embodiment of the present disclosure.
FIG. 5 is a diagram schematically showing a reference differential profile according to an embodiment of the present disclosure.
FIG. 6 is a diagram schematically showing a differential profile according to an embodiment of the present disclosure.
FIG. 7 is a diagram schematically showing a criterion differential profile according to an embodiment of the present disclosure.
FIG. 8 is a diagram schematically showing an exemplary configuration of a battery pack according to another embodiment of the present disclosure.
FIG. 9 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

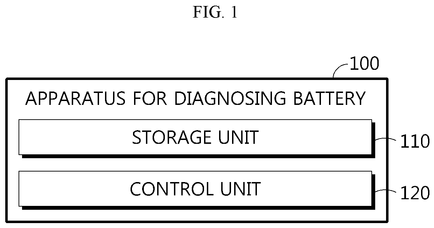

FIG. 1 is a diagram schematically illustrating an apparatus 100 for diagnosing a battery according to an embodiment of the present disclosure.

Referring to FIG. 1, the apparatus 100 for diagnosing a battery according to an embodiment of the present disclosure may include a storage unit 110 and a control unit 120.

The storage unit 110 may be configured to store bank information about the voltage and capacity of each of a plurality of battery banks included in the battery module.

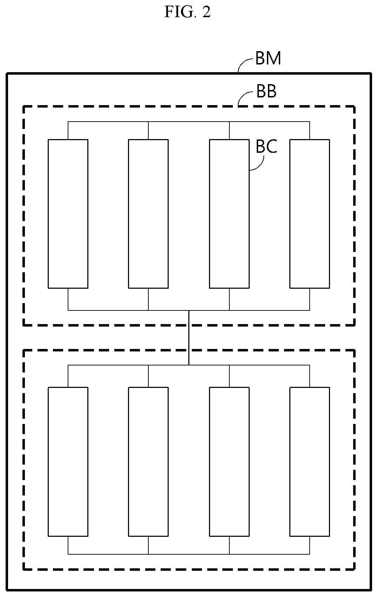

FIG. 2 is a diagram schematically showing an exemplary configuration of a battery bank BB and a battery module BM according to an embodiment of the present disclosure.

In the embodiment of FIG. 2, a plurality of battery cells BC may be connected in parallel. The battery bank BB may include a plurality of battery cells BC connected in parallel. Also, a plurality of battery banks BB may be connected in series. The battery module BM may include a plurality of battery banks BB connected in series. Below, the connection configuration of the battery cells BC, the battery banks BB, and the battery modules BM will be described based on the embodiment of FIG. 2.

Here, the battery cell refers to an independent cell that has a negative electrode terminal and a positive electrode terminal and is physically separable. As an example, a lithium-ion battery or a lithium polymer battery may be considered a battery cell.

The storage unit 110 may store a battery bank profile representing the corresponding relationship between voltage and capacity of each of a plurality of battery banks. For example, if the X-axis is set to capacity and the Y-axis is set to voltage, the battery bank profile may be expressed as an X-Y graph. Additionally, when voltage is expressed as 'V' and capacity is expressed as 'Q', the battery bank profile may be expressed as a 'Q-V profile'. That is, the storage unit 110 may store bank information, which is information representing the corresponding relationship between voltage and capacity of each of the plurality of battery banks.

The control unit 120 may be configured to generate a differential profile for each of the plurality of battery banks based on the bank information.

Specifically, the control unit 120 may generate at least one of a differential profile DP1 representing the corresponding relationship between voltage and differential capacity and a differential profile DP2 representing the corresponding relationship between capacity and differential voltage based on the bank information stored in the storage unit 110.

Additionally, the control unit 120 may diagnose the state of the battery module based on the generated differential profile.

Below, an embodiment in which the control unit 120 generates a differential profile DP1 representing the corresponding relationship between voltage and differential capacity and diagnoses the state of the battery bank based on the differential profile DP1 will first be described. Additionally, an embodiment in which the control unit 120 generates a differential profile DP2 and diagnoses the state of the battery bank based on the differential profile DP2 will be described later.

Here, the differential capacity may refer to a change rate of capacity with respect to voltage. For example, when voltage is expressed as 'V' and capacity is expressed as 'Q', the differential capacity may be expressed as 'dQ/dV'.

The control unit 120 may generate a differential profile DP1 representing the corresponding relationship between voltage and differential capacity based on the bank information stored in the storage unit 110. For example, if the X-axis is set to voltage and the Y-axis is set to differential capacity, the differential profile DP1 may be expressed as an X-Y graph. Additionally, when voltage is expressed as 'V' and differential capacity is expressed as 'dQ/dV', the differential profile DP1 may be expressed as a 'V-dQ/dV profile'. Here, the differential capacity may refer to a change rate of capacity with respect to voltage. For example, when voltage is expressed as 'V' and capacity is expressed as 'Q', the differential capacity may be expressed as 'dQ/dV'.

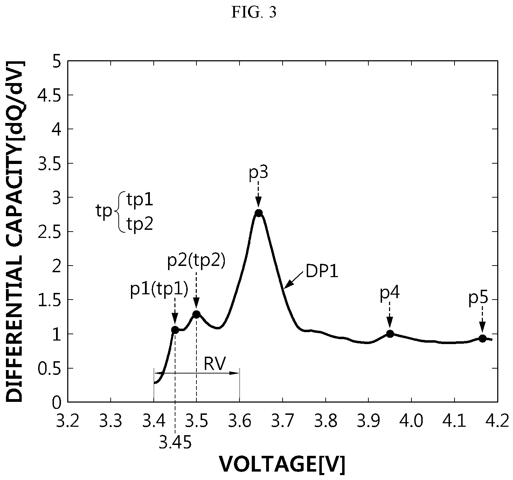

FIG. 3 is a diagram schematically showing a differential profile DP1 according to an embodiment of the present disclosure. Specifically, the embodiment of FIG. 3 is a diagram showing the differential profile DP1 for one of the plurality of battery banks included in the battery module. In the embodiment of FIG. 3, the voltage section of the battery bank may be 3.4 [V] to 4.2 [V].

The control unit 120 may be configured to determine a target peak tp included in the preset criterion voltage section RV in each of the generated plurality of differential profiles DP1.

Specifically, the target peak tp may refer to a peak belonging to a preset criterion voltage section RV among a plurality of peaks included in the plurality of differential profiles DP1. Here, the peak may be a point where the change rate of differential capacity with respect to voltage is 0 and has a convex upward shape. Specifically, the slope of the differential profile DP1 may change from positive to negative based on the peak.

For example, in the embodiment of FIG. 3, it is assumed that the criterion voltage section RV is preset to 3.4 [V] to 3.6 [V]. The differential profile DP1 may include a plurality of peaks p1, p2, p3, p4, p5. Here, the voltage corresponding to the first peak p1 may be 3.45 [V], and the voltage corresponding to the second peak p2 may be 3.5 [V]. That is, only the first peak p1 and the second peak p2 may belong to the criterion voltage section RV, and the third peak p3, the fourth peak p4, and the fifth peak p5 may not belong to the criterion voltage section RV. Therefore, the control unit 120 may determine the first peak p1 and the second peak p2 as the target peak tp. Preferably, the control unit 120 may determine the first peak p1 as a first target peak tp1 and the second peak p2 as a second target peak tp2.

The control unit 120 may be configured to diagnose the state of the corresponding battery bank based on the determined target peak tp.

Specifically, the control unit 120 may be configured to diagnose the state of the battery bank as a normal state or an abnormal state based on the number of determined target peaks tp. Preferably, the control unit 120 may compare the number of target peaks tp and the number of criterion peaks rp of a preset criterion differential profile RP1 and diagnose the state of the battery bank according to the comparison result.

Here, the criterion differential profile RP1 may be preset to represent the corresponding relationship between the voltage and differential capacity of the criterion battery bank. That is, the control unit 120 may compare the number of target peaks tp included in the criterion voltage section RV of the differential profile DP1 and the number of criterion peaks rp included in the criterion voltage section RV of the criterion differential profile RP1.

For example, the criterion battery bank may be a test bank designed to generate the criterion differential profile RP1 or a battery bank in a BOL (Beginning of life) state. Preferably, the criterion battery bank is set for each of the plurality of battery banks, and the battery bank in the BOL state may be set as the criterion battery bank. That is, for each of the plurality of battery banks, the differential profile of the battery bank (criterion battery bank) in the BOL state may be set as the criterion differential profile RP1 of the battery bank.

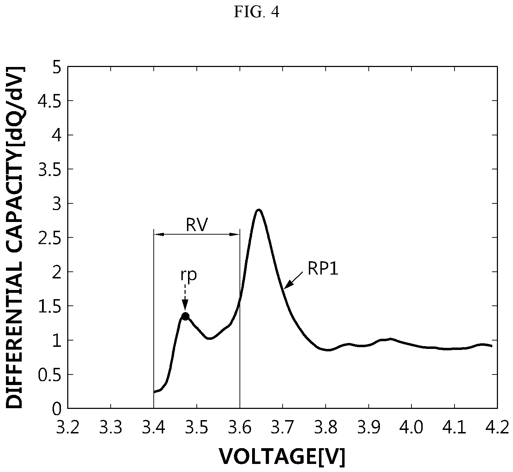

FIG. 4 is a diagram schematically showing a criterion differential profile RP1 according to an embodiment of the present disclosure.

Specifically, the embodiment of FIG. 4 is a diagram showing the criterion differential profile RP1 for the criterion battery bank. In the embodiment of FIG. 4, the voltage section of the criterion battery bank may be 3.4 [V] to 4.2 [V].

Preferably, the criterion battery bank according to the embodiment of FIG. 4 may correspond to the battery bank according to the embodiment of FIG. 3. For example, the criterion differential profile RP1 according to the embodiment of FIG. 4 may be the differential profile DP1 for the BOL state of the battery bank according to the embodiment of FIG. 3. The criterion voltage section RV of the criterion differential profile RP1 may include one criterion peak rp.

In one embodiment, the control unit 120 may diagnose the state of the battery bank, where the number of determined target peaks tp is less than or equal to the number of criterion peaks rp included in the criterion voltage section RV of the preset criterion differential profile RP1, as a normal state. Conversely, the control unit 120 may diagnose the state of the battery bank, where the number of determined target peaks tp exceeds the number of criterion peaks rp, as an abnormal state.

If the number of target peaks tp exceeds the number of criterion peaks rp, it can be seen that imbalanced deterioration of the plurality of battery cells included in the battery bank has occurred.

In the BOL state, the states of the plurality of battery cells may be substantially the same. However, if the plurality of battery cells deteriorate unbalanced as the battery bank is operated, the number of target peaks tp may exceed the number of criterion peaks rp. Conversely, even if the battery bank is operated, if the plurality of battery cells deteriorates in a balanced manner, the number of target peaks tp may be less than or equal to the number of criterion peaks rp. This is because the state difference of the plurality of battery cells due to imbalance deterioration appear as an increased number of target peaks tp in the differential profile DP1 for the battery bank. Therefore, the control unit 120 may diagnose the state of the battery bank as a normal state or an abnormal state according to the result of comparing the number of determined target peaks tp and the number of preset criterion peaks rp.

For example, in the embodiment of FIG. 3, the differential profile DP1 may include a first target peak tp1 and a second target peak tp2. Also, in the embodiment of FIG. 4, the criterion differential profile RP1 may include one criterion peak rp. Because the number of target peaks tp exceeds the number of criterion peaks rp, the control unit 120 may diagnose the state of the battery bank as an abnormal state.

The apparatus 100 for diagnosing a battery has the advantage of accurately diagnosing the state of the battery bank based on the number of target peaks tp, which reflects the imbalanced deterioration of the plurality of battery cells.

In another embodiment, the control unit 120 may be configured to diagnose the state of the corresponding battery bank as an abnormal state, when the number of determined target peaks tp exceeds the number of criterion peaks rp and the voltage difference between the target peaks tp is greater than or equal to a preset threshold voltage.

The control unit 120 may diagnose the state of the battery bank by considering not only the number of target peaks tp but also the voltage difference between the target peaks tp. As previously explained, if a state difference occurs in the plurality of battery cells, the number of target peaks tp may exceed the number of criterion peaks rp.

The control unit 120 may calculate the voltage difference between the target peaks tp, when the number of target peaks tp exceeds the number of criterion peaks rp. Also, the control unit 120 may compare the preset threshold voltage and the calculated voltage difference. Here, the threshold voltage may be preset to indicate that the degree of imbalance deterioration between the plurality of battery cells is severe enough to determine the state of the battery bank as an abnormal state. For example, the threshold voltage may be preset to a value of 0.01 [V] or higher. Preferably, the threshold voltage may be preset to 0.02 [V].

For example, in the embodiment of FIG. 3, the voltage of the first target peak tp1 may be 3.45 [V], and the voltage of the second target peak tp2 may be 3.5 [V]. The control unit 120 may calculate the voltage difference between the first target peak tp1 and the second target peak tp2 as 0.5 [V]. Since the calculated voltage difference (0.5 [V]) is more than or equal to the preset threshold voltage (0.02 [V]), the control unit 120 may diagnose the state of the battery bank as an abnormal state.

The apparatus 100 for diagnosing a battery has the advantage of more accurately diagnosing the state of the battery bank based on the number of target peaks tp and the voltage difference between the target peaks tp.

Hereinafter, with reference to FIGS. 3 to 5, the criterion voltage section RV from which the criterion peak rp and the target peak tp can be determined will be described.

The control unit 120 may be configured to select a criterion capacity in which the corresponding differential voltage in a reference differential profile RP2 preset for a criterion battery bank is minimum.

Here, the reference differential profile RP2 may be preset to represent the corresponding relationship between the capacity and differential voltage of the criterion battery bank. Also, the differential voltage may represent the change rate of voltage with respect to capacity. For example, when voltage is expressed as 'V' and capacity is expressed as 'Q', the differential voltage may be expressed as 'dV/dQ'.

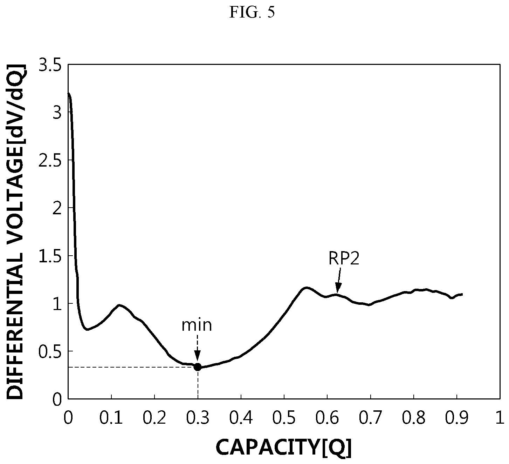

FIG. 5 is a diagram schematically showing a reference differential profile RP2 according to an embodiment of the present disclosure. Specifically, in the embodiment of FIG. 5, the capacity is a capacity normalized to the range of 0 to 1. In the embodiment of FIG. 5, when the X-axis is set to capacity and the Y-axis is set to the differential voltage, the reference differential profile RP2 may be expressed as an X-Y graph. Additionally, when the capacity is expressed as 'Q' and the differential voltage is expressed as 'dV/dQ', the reference differential profile RP2 may be expressed as a 'Q-dV/dQ profile'.

In the embodiment of FIG. 5, the control unit 120 may select a point (min) at which the differential voltage is minimum in the reference differential profile RP2. Here, the capacity corresponding to the point (min) may be 0.3. Therefore, the control unit 120 may select the criterion capacity as 0.3.

The control unit 120 may be configured to select a criterion voltage corresponding to the criterion capacity in a criterion bank profile preset for the criterion battery bank.

Here, the criterion bank profile may be preset to represent the corresponding relationship between the voltage and capacity of the criterion battery bank. For example, the criterion bank profile may be a profile in which the corresponding voltage and capacity of the criterion battery are mapped.

The control unit 120 may select a criterion voltage corresponding to the criterion capacity using the criterion bank profile. For example, the criterion voltage selected by the control unit 120 may be 3.6 [V].

The control unit 120 may be configured to set a voltage section less than or equal to the criterion voltage as the criterion voltage section RV.

For example, in the embodiment of FIG. 3, the control unit 120 may set a voltage section of 3.6 [V] or less as the criterion voltage section RV. Specifically, since the voltage section of the battery bank is 3.4 [V] to 4.2 [V], the control unit 120 may set the voltage section of 3.4 [V] to 3.6 [V] as the criterion voltage section RV.

The apparatus 100 for diagnosing a battery may determine the peak included in the criterion voltage section RV as the target peak tp in order to diagnose the state of the battery bank based on the imbalance deterioration of the negative electrode of the battery cell. That is, the criterion voltage section RV may be a voltage section that reflects the deterioration state of the negative electrode. Also, this deterioration state of the negative electrode may be clearly seen in the differential profile DP1. Accordingly, the apparatus 100 for diagnosing a battery may diagnose the state of the battery bank based on whether the negative electrode imbalance deterioration has occurred in the plurality of battery cells included in the battery bank.

Below, an embodiment in which the control unit 120 generates a differential profile DP2 representing the corresponding relationship between capacity and differential voltage and diagnoses the state of the battery bank based on the differential profile DP2 will be described.

Here, the differential voltage may represent the change rate of voltage with respect to capacity. For example, when voltage is expressed as 'V' and capacity is expressed as 'Q', the differential voltage may be expressed as 'dV/dQ'.

The control unit 120 may generate a differential profile DP2 representing the corresponding relationship between capacity and differential voltage based on the bank information stored in the storage unit 110. For example, if the X-axis is set to capacity and the Y-axis is set to the differential voltage, the differential profile DP2 may be expressed as an X-Y graph. Additionally, when capacity is expressed as 'Q' and differential voltage is expressed as 'dV/dQ', the differential profile DP2 may be expressed as a 'Q-dV/dQ profile'.

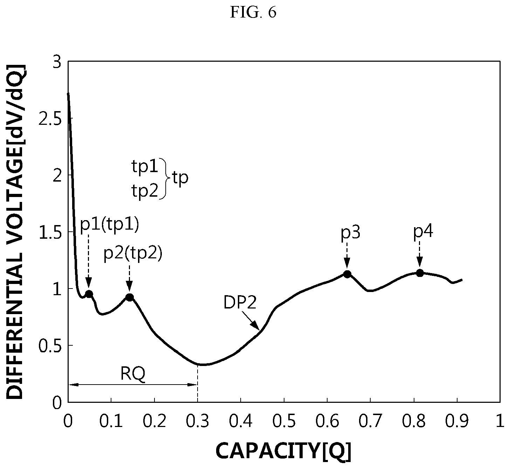

FIG. 6 is a diagram schematically showing a differential profile DP2 according to an embodiment of the present disclosure.

Specifically, the embodiment of FIG. 6 is a diagram showing the differential profile DP2 for one of the plurality of battery banks included in the battery module. In the embodiment of FIG. 6, the capacity section of the battery bank may be normalized to 0 to 1. Please note that the normalization of capacity is for convenience of explanation, and the capacity normalization process may be omitted.

The control unit 120 may be configured to determine the target peak tp included in a preset criterion capacity section RQ in each of the generated plurality of differential profiles DP2.

Specifically, the target peak tp may refer to a peak belonging to the preset criterion capacity section RQ among the plurality of peaks included in the plurality of differential profiles DP2. Here, the peak may be a point where the change rate of differential voltage with respect to capacity is 0 and has a convex upward shape. Specifically, the slope of the differential profile DP2 may change from positive to negative based on the peak.

For example, in the embodiment of FIG. 6, it is assumed that criterion capacity section RQ is preset to 0 to 0.3. The differential profile DP2 may include a plurality of peaks p1, p2, p3, p4. Here, only the first peak p1 and the second peak p2 may belong to the criterion capacity section RQ, and the third peak p3 and the fourth peak p4 may not belong to the criterion capacity section RQ. Therefore, the control unit 120 may determine the first peak p1 and the second peak p2 as the target peak tp. Preferably, the control unit 120 may determine the first peak p1 as a first target peak tp1 and the second peak p2 as a second target peak tp2.

The control unit 120 may be configured to diagnose the state of the corresponding battery bank based on the determined target peak tp.

Specifically, the control unit 120 may be configured to diagnose the state of the battery bank as a normal state or an abnormal state based on the number of determined target peaks tp. Preferably, the control unit 120 may compare the number of target peaks tp and the number of criterion peaks rp of a preset criterion differential profile RP and diagnose the state of the battery bank according to the comparison result.

Here, the criterion differential profile RP may be preset to represent the corresponding relationship between the capacity and differential voltage of the criterion battery bank. That is, the control unit 120 may compare the number of target peaks tp included in the criterion capacity section RQ of the differential profile DP2 and the number of criterion peaks rp included in the criterion capacity section RQ of the criterion differential profile RP.

For example, the criterion battery bank may be a test bank designed to generate the criterion differential profile RP or a battery bank in a BOL state. Preferably, the criterion battery bank is set for each of the plurality of battery banks, and the battery bank in the BOL state may be set as the criterion battery bank. That is, for each of the plurality of battery banks, the differential profile DP2 of the battery bank (criterion battery bank) in the BOL state may be set as the criterion differential profile RP of the battery bank.

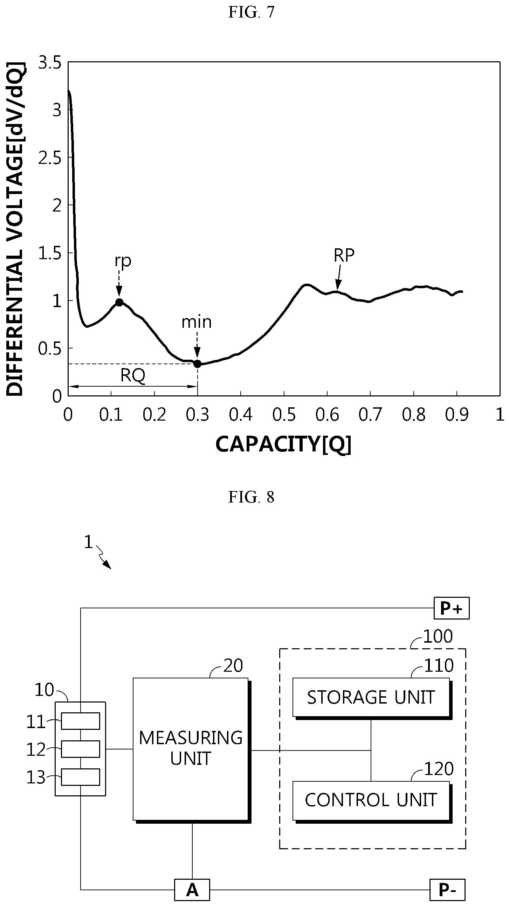

FIG. 7 is a diagram schematically showing a criterion differential profile according to an embodiment of the present disclosure.

Specifically, the embodiment of FIG. 7 is a diagram showing the criterion differential profile RP for the criterion battery bank. In the embodiment of FIG. 7, the capacity section of the criterion battery bank may be normalized to 0 to 1. As explained previously, the normalization of capacity is for convenience of explanation.

Preferably, the criterion battery bank according to the embodiment of FIG. 7 may correspond to the battery bank according to the embodiment of FIG. 6. For example, the criterion differential profile RP according to the embodiment of FIG. 7 may be the differential profile DP2 for the BOL state of the battery bank according to the embodiment of FIG. 6. The criterion capacity section RQ of the criterion differential profile RP may include one criterion peak rp.

In one embodiment, the control unit 120 may diagnose the state of the battery bank, where the number of determined target peaks tp is less than or equal to the number of criterion peaks rp included in the criterion capacity section RQ of the preset criterion differential profile RP, as a normal state. Conversely, the control unit 120 may diagnose the state of the battery bank, where the number of determined target peaks tp exceeds the number of criterion peaks rp, as an abnormal state.

If the number of target peaks tp exceeds the number of criterion peaks rp, it can be seen that imbalanced deterioration of the plurality of battery cells included in the battery bank has occurred.

In the BOL state, the states of the plurality of battery cells may be substantially the same. However, if the plurality of battery cells deteriorate unbalanced as the battery bank is operated, the number of target peaks tp may exceed the number of criterion peaks rp. Conversely, even if the battery bank is operated, if the plurality of battery cells deteriorates in a balanced manner, the number of target peaks tp may be less than or equal to the number of criterion peaks rp. This is because the state difference of the plurality of battery cells due to imbalance deterioration appear as an increased number of target peaks tp in the differential profile DP2 for the battery bank. Therefore, the control unit 120 may diagnose the state of the battery bank as a normal state or an abnormal state according to the result of comparing the number of determined target peaks tp and the number of preset criterion peaks rp.

For example, in the embodiment of FIG. 6, the differential profile DP2 may include a first target peak tp1 and a second target peak tp2. Also, in the embodiment of FIG. 7, the criterion differential profile RP may include one criterion peak rp. Because the number of target peaks tp exceeds the number of criterion peaks rp, the control unit 120 may diagnose the state of the battery bank as an abnormal state.

The apparatus 100 for diagnosing a battery has the advantage of accurately diagnosing the state of the battery bank based on the number of target peaks tp, which reflects the imbalanced deterioration of the plurality of battery cells.

In another embodiment, the control unit 120 may be configured to diagnose the state of the corresponding battery bank as an abnormal state, when the number of determined target peaks tp exceeds the number of criterion peaks rp and the capacity difference between the target peaks tp is greater than or equal to a preset threshold value.

The control unit 120 may diagnose the state of the battery bank by considering not only the number of target peaks tp but also the capacity difference between the target peaks tp. As previously explained, if a state difference occurs in the plurality of battery cells, the number of target peaks tp may exceed the number of criterion peaks rp.

The control unit 120 may calculate the capacity difference between the target peaks tp, when the number of target peaks tp exceeds the number of criterion peaks rp. Also, the control unit 120 may compare the preset threshold value and the calculated capacity difference. Here, the threshold value may be preset to indicate that the degree of imbalance deterioration between the plurality of battery cells is severe enough to determine the state of the battery bank as an abnormal state. For example, the threshold value may be preset to 3%. The control unit 120 may diagnose the state of the battery bank as an abnormal state, when the capacity difference between the target peaks tp is greater than or equal to the preset threshold value (3%). In one embodiment, the control unit 120 may calculate the capacity difference between the target peaks by calculating the formula "(capacity of second target peak - capacity of first target peak) ÷ capacity of first target peak × 100". Also, the control unit 120 may compare the calculated capacity difference and the threshold value.

The apparatus 100 for diagnosing a battery has the advantage of more accurately diagnosing the state of the battery bank based on the number of target peaks tp and the capacity difference between the target peaks tp.

Hereinafter, with reference to FIGS. 6 and 7, the criterion capacity section RQ from which the criterion peak rp and the target peak tp can be determined will be described.

The control unit 120 may be configured to select a criterion capacity in which the corresponding differential voltage in a criterion differential profile RP preset for a criterion battery bank is minimum.

Here, the criterion differential profile RP may be preset to represent the corresponding relationship between the capacity and differential voltage of the criterion battery bank. Also, the differential voltage may represent the change rate of voltage with respect to capacity. For example, when voltage is expressed as 'V' and capacity is expressed as 'Q', the differential voltage may be expressed as 'dV/dQ'.

In the embodiment of FIG. 7, the control unit 120 may select a point (min) at which the differential voltage is minimum in the criterion differential profile RP. Here, the capacity corresponding to the point (min) may be 0.3. Therefore, the control unit 120 may select the criterion capacity as 0.3.

The control unit 120 may be configured to set a capacity section less than or equal to the criterion capacity as the criterion capacity section RQ.

For example, in the embodiment of FIG. 6, the control unit 120 may set a capacity section of 0.3 or less as the criterion capacity section RQ. Specifically, since the capacity section of the battery bank is 0 to 1, the control unit 120 may set the capacity section of 0 to 0.3 as the criterion capacity section RQ. Here, please note that the capacity section of 0 to 0.3 is a normalized capacity section for the actual capacity section of the battery bank.

The apparatus 100 for diagnosing a battery may determine the peak included in the criterion capacity section RQ as the target peak tp in order to diagnose the state of the battery bank based on the imbalance deterioration of the negative electrode of the battery cell. That is, the criterion capacity section RQ may be a capacity section that reflects the deterioration state of the negative electrode. Also, this deterioration state of the negative electrode may be clearly seen in the differential profile DP2. Accordingly, the apparatus 100 for diagnosing a battery may diagnose the state of the battery bank based on whether the negative electrode imbalance deterioration has occurred in the plurality of battery cells included in the battery bank.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

Here, the storage unit 110 may store data necessary for operation and function of each component of the apparatus 100 for diagnosing a battery, data generated in the process of performing the operation or function, or the like. The storage unit 110 is not particularly limited in its kind as long as it is a known information storage means that can record, erase, update and read data. As an example, the information storage means may include RAM, flash memory, ROM, EEPROM, registers, and the like. In addition, the storage unit 110 may store program codes in which processes executable by the control unit 120 are defined.

Below, an embodiment in which the control unit 120 diagnoses the state of the battery module will be described in detail.

The control unit 120 may be configured to calculate an abnormal ratio representing the ratio of abnormal state among the plurality of battery banks.

Specifically, the control unit 120 may calculate the ratio of the number of battery banks diagnosed as being in an abnormal state to the number of the plurality of battery banks.

**In** one embodiment, it is assumed that the number of the plurality of battery banks included in the battery module is N, and the number of battery banks diagnosed as being in an abnormal state is M. The control unit 120 may calculate the abnormal ratio by calculating the formula "M ÷ N" or "M ÷ N × 100". The formula for calculating the abnormal ratio may be appropriately selected depending on the unit of the abnormal ratio to be calculated.

The control unit 120 may be configured to diagnose the state of the battery module as a normal state or an abnormal state based on the abnormal ratio.

For example, if the abnormal ratio is less than a preset threshold ratio, the control unit 120 may diagnose the state of the battery module as a normal state. Conversely, if the abnormal ratio is greater than or equal to the threshold ratio, the control unit 120 may diagnose the state of the battery module as an abnormal state.

The apparatus 100 for diagnosing a battery may further diagnose the state of the battery module based on the state of the plurality of battery banks. **In** other words, the apparatus 100 for diagnosing a battery may diagnose the state of the battery module as well as the state of each of the plurality of battery banks.

The control unit 120 may be configured to change a charging condition preset for the battery module when the state of the battery module is diagnosed as an abnormal state.

Specifically, when the state of the battery module is diagnosed as an abnormal state, the control unit 120 may be configured to alleviate the rapid charging condition of the battery module by reducing a maximum charging C-rate preset for the battery module.

Here, the rapid charging condition refers to a charging C-rate (Current rate) condition that can be applied to the battery module.

If rapid charging continues for a battery module that is diagnosed as in an abnormal state, lithium plating (Li plating) phenomenon where lithium metal is precipitated on the surface of the negative electrode of the battery cell may occur and deterioration of the battery cell may accelerate. Therefore, the control unit 120 may alleviate the rapid charging condition to increase the lifespan of the battery module.

In the embodiment of FIG. 3, when the control unit 120 diagnoses the state of the battery bank based on the differential profile DP1, the control unit 120 may be configured to reduce the maximum charging C-rate set for the remaining voltage sections excluding the criterion voltage section RV among all voltage sections of the battery module.

In the embodiment of FIG. 6, when the control unit 120 diagnoses the state of the battery bank based on the differential profile DP2, the control unit 120 may be configured to reduce the maximum charging C-rate set for the remaining capacity sections excluding the criterion capacity section RQ among all capacity sections of the battery module.

For example, when the battery module is completely discharged, it is assumed that the rapid charging condition for the battery module is set to 2 C in order to fully charge the battery module within 30 minutes. In other words, assume that the maximum charging C-rate for the battery module is set to 2 C. If the state of the battery module is diagnosed as an abnormal state, the control unit 120 may reduce the maximum charging C-rate set in the battery module from 2 C to 1 C.

The apparatus 100 for diagnosing a battery may prevent accelerated deterioration of a battery module diagnosed as being in an abnormal state by reducing the maximum charging C-rate set for the battery module. Additionally, by reducing the maximum charging C-rate, precipitation of lithium metal due to rapid charging may be prevented. Therefore, the occurrence of various problems due to the lithium plating phenomenon may be prevented in advance.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the storage unit 110 and the control unit 120 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 8 is a diagram schematically showing an exemplary configuration of a battery pack 1 according to another embodiment of the present disclosure.

The battery module 10 may include a plurality of battery banks 11, 12, 13. For example, in the embodiment of FIG. 8, the plurality of battery banks 11, 12, 13 may be connected to each other in series.

The measuring unit 20 may measure the voltage of each of the plurality of battery banks 11, 12, 13. Additionally, the measuring unit 20 may measure the voltage of the battery module 10.

In addition, the measuring unit 20 may be connected to a current measuring unit A. For example, the current measuring unit A may be an ammeter or shunt resistor that can measure the charging current and discharging current of the battery module 10. The measuring unit 20 may calculate the charging amount by measuring the charging current of the battery module 10 through the current measuring unit A. Additionally, the measuring unit 20 may calculate the discharge amount by measuring the discharging current of the battery module 10 through the current measuring unit A.

An external device may be connected to a positive electrode terminal P+ and a negative electrode terminal P- of the battery pack 1. For example, the external device may be a charging/discharging device or a motor of an electric vehicle that receives power from the battery pack 1.

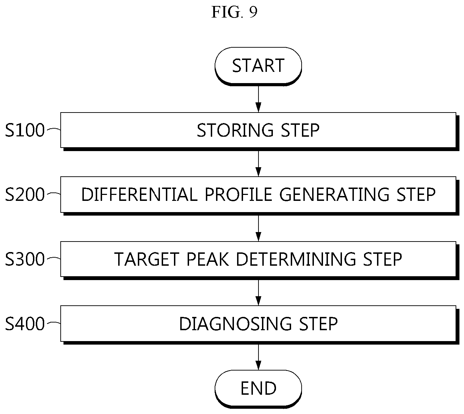

FIG. 9 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be briefly described or omitted.

The storing step (S100) is a step of storing bank information about voltage and capacity of each of a plurality of battery banks included in a battery module, and may be performed by the storage unit 110.

For example, the storage unit 110 may store a battery bank profile representing the corresponding relationship between the voltage and capacity of each of the plurality of battery banks.

The differential profile generating step (S200) is a step of generating a differential profile for each of the plurality of battery banks based on the bank information, and may be performed by the control unit 120.

For example, in the embodiment of FIG. 3, the control unit 120 may generate a differential profile DP1 representing the corresponding relationship between the voltage and differential capacity based on the bank information stored in the storage unit 110.

As another example, in the embodiment of FIG. 6, the control unit 120 may generate a differential profile DP2 representing the corresponding relationship between the capacity and differential voltage based on the bank information stored in the storage unit 110.

The peak target determining step (S300) is a step of determining a target peak tp in each of the generated plurality of differential profiles, and may be performed by the control unit 120.

For example, in the embodiment of FIG. 3, it is assumed that the criterion voltage section RV is preset to 3.4 [V] to 3.6 [V]. The control unit 120 may determine the first peak p1 as a first target peak tp1 and the second peak p2 as a second target peak tp2 among the plurality of peaks p1, p2, p3, p4, p5 included in the differential profile DP1.

For example, in the embodiment of FIG. 6, it is assumed that criterion capacity section RQ is preset to 0 to 0.3. The control unit 120 may determine the first peak p1 as a first target peak tp1 and the second peak p2 as a second target peak tp2 among the plurality of peaks p1, p2, p3, p4 included in the differential profile DP2.

The diagnosing step (S400) is a step of diagnosing the state of the corresponding battery bank based on the determined target peak tp, and may be performed by the control unit 120.

In the embodiment of FIGS. 3 to 5, the control unit 120 may diagnose the state of the battery bank, where the number of determined target peaks tp is less than or equal to the number of criterion peaks rp included in the criterion voltage section RV of the preset criterion differential profile RP1, as a normal state. Conversely, the control unit 120 may diagnose the state of the battery bank, where the number of determined target peaks tp exceeds the number of criterion peaks rp, as an abnormal state. In addition, the control unit 120 may be configured to diagnose the state of the corresponding battery bank as an abnormal state, when the number of determined target peaks tp exceeds the number of criterion peaks rp and the voltage difference between the target peaks tp is greater than or equal to a preset threshold voltage.

In the embodiment of FIGS. 6 and 7, the control unit 120 may diagnose the state of the battery bank, where the number of determined target peaks tp is less than or equal to the number of criterion peaks rp included in the criterion capacity section RQ of the preset criterion differential profile RP, as a normal state. Conversely, the control unit 120 may diagnose the state of the battery bank, where the number of determined target peaks tp exceeds the number of criterion peaks rp, as an abnormal state. In addition, the control unit 120 may be configured to diagnose the state of the corresponding battery bank as an abnormal state, when the number of determined target peaks tp exceeds the number of criterion peaks rp and the capacity difference between the target peaks tp is greater than or equal to the preset threshold value.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
10: battery module
11, 12, 13: battery bank
20: measuring unit
100: apparatus for diagnosing a battery
110: storage unit
120: control unit

## Claims

1. An apparatus for diagnosing a battery, comprising:
a storage unit configured to store bank information about voltage and capacity of each of a plurality of battery banks included in a battery module; and
a control unit configured to generate a differential profile for each of the plurality of battery banks based on the bank information, determine a target peak in each of the generated plurality of differential profiles, and diagnose the state of the corresponding battery bank based on the determined target peak.

2. The apparatus for diagnosing a battery according to claim 1,
wherein the control unit is configured to generate a differential profile representing the corresponding relationship between the voltage and a differential capacity of each of the plurality of battery banks, and determine the target peak included in a preset criterion voltage section in each of the generated plurality of differential profiles.

3. The apparatus for diagnosing a battery according to claim 2,
wherein the control unit is configured to diagnose the state of a battery bank, where the number of the determined target peaks is less than or equal to the number of criterion peaks included in the criterion voltage section of a preset criterion differential profile, as a normal state,
wherein the control unit is configured to diagnose the state of a battery bank, where the number of the determined target peaks exceeds the number of the criterion peaks, as an abnormal state, and
wherein the criterion differential profile is preset to show the corresponding relationship between the voltage and the differential capacity of a criterion battery bank.

4. The apparatus for diagnosing a battery according to claim 3,
wherein the control unit is configured to diagnose the state of the corresponding battery bank as an abnormal state, when the number of the determined target peaks exceeds the number of the criterion peaks and a voltage difference between the target peaks is greater than or equal to a preset threshold voltage.

5. The apparatus for diagnosing a battery according to claim 1,
wherein the control unit is configured to generate a differential profile representing the corresponding relationship between the capacity and a differential voltage of each of the plurality of battery banks based on the bank information, and determine a target peak included in a preset criterion capacity section in each of the generated plurality of differential profiles.

6. The apparatus for diagnosing a battery according to claim 5,
wherein the control unit is configured to diagnose the state of a battery bank, where the number of the determined target peaks is less than or equal to the number of criterion peaks included in the criterion capacity section of a preset criterion differential profile, as a normal state,
wherein the control unit is configured to diagnose the state of a battery bank, where the number of the determined target peaks exceeds the number of the criterion peaks, as an abnormal state, and
wherein the criterion differential profile is preset to show the corresponding relationship between the capacity and the differential voltage of a criterion battery bank.

7. The apparatus for diagnosing a battery according to claim 6,
wherein the control unit is configured to diagnose the state of the corresponding battery bank as an abnormal state, when the number of the determined target peaks exceeds the number of the criterion peaks and a capacity difference between the target peaks is greater than or equal to a preset threshold value.

8. The apparatus for diagnosing a battery according to claim 1,
wherein the control unit is configured to calculate an abnormal ratio representing a ratio of an abnormal state among the plurality of battery banks, and diagnose the state of the battery module as a normal state or an abnormal state based on the abnormal ratio.

9. The apparatus for diagnosing a battery according to claim 8,
wherein when the abnormal ratio is less than a preset threshold ratio, the control unit is configured to diagnose the state of the battery module as the normal state, and
wherein when the abnormal ratio is greater than or equal to the threshold ratio, the control unit is configured to diagnose the state of the battery module as the abnormal state.

10. The apparatus for diagnosing a battery according to claim 8,
wherein the control unit is configured to change a charging condition preset for the battery module, when the state of the battery module is diagnosed as an abnormal state.

11. The apparatus for diagnosing a battery according to claim 10,
wherein the control unit is configured to alleviate a rapid charging condition of the battery module by reducing a maximum charging C-rate preset for the battery module, when the state of the battery module is diagnosed as an abnormal state.

12. The apparatus for diagnosing a battery according to claim 2,
wherein the control unit is configured to select a criterion capacity in which the differential voltage corresponding to a reference differential profile preset for a criterion battery bank is minimum, select a criterion voltage corresponding to the criterion capacity in a criterion bank profile preset for the criterion battery bank, and set a voltage section less than or equal to the criterion voltage as the criterion voltage section,
wherein the reference differential profile is preset to represent the corresponding relationship between the capacity and the differential voltage of the criterion battery bank, and
wherein the criterion bank profile is preset to represent the corresponding relationship between the voltage and the capacity of the criterion battery bank.

13. The apparatus for diagnosing a battery according to claim 5,
wherein the control unit is configured to select a criterion capacity in which the corresponding differential voltage in a preset criterion differential profile is minimum, and set a capacity section less than or equal to the criterion capacity as the criterion capacity section.

14. A battery pack, comprising the apparatus for diagnosing a battery according to any one of claims 1 to 13.

15. A method for diagnosing a battery, comprising:
a storing step of storing bank information about voltage and capacity of each of a plurality of battery banks included in a battery module;
a differential profile generating step of generating a differential profile for each of the plurality of battery banks based on the bank information;
a target peak determining step of determining a target peak in each of the generated plurality of differential profiles; and
a diagnosing step of diagnosing the state of the corresponding battery bank based on the determined target peak.
